# FASCICULE DE BREVET EUROPEEN

(11) **EP 2 622 658 B1**
(45) Date de publication et mention de la délivrance du brevet: **29.04.2015**
(21) Numéro de dépôt: 11740890.6
(22) Date de dépôt: 28.07.2011
(51) Int. Cl.: H01L 35/30, F28F 1/32

(54) **DISPOSITF THERMO ÉLECTRIQUE, NOTAMMENT DESTINÉ À GÉNÉRER UN COURANT ÉLECTRIQUE DANS UN VÉHICULE AUTOMOBILE**
THERMOELEKTRISCHE VORRICHTUNG, IM BESONDEREN ZUR ERZEUGUNG VON STROM BEI EINEM KRAFTFAHRZEUG
THERMOELECTRIC DEVICE, ESPECIALLY INTENDED TO GENERATE AN ELECTRICAL CURRENT IN AN AUTOMOTIVE VEHICLE

(30) Priorité: 29.09.2010 FR 1057878
(43) Date de publication de la demande: 07.08.2013
(73) Titulaire: Valeo Systemes Thermiques, 78320 Le Mesnil Saint Denis (FR)
(72) Inventeur: TONDELLI, Stéphane, F-78870 Bailly (FR); SIMONIN, Michel, F-78960 Voisins Le Bretonneux (FR)
(74) Mandataire: Delplanque, Arnaud
(86) Numéro de dépôt international: PCT/EP2011/063033
(87) Numéro de publication internationale: WO 2012/041562

(56) Documents cités:
- EP-A2- 1 515 376
- WO-A1-96/11372
- WO-A1-2009/156361
- US-A- 5 584 183

## Description

La présente invention concerne un dispositif thermo électrique, notamment destiné à générer un courant électrique dans un véhicule automobile.

Il a déjà été proposé des dispositifs thermo électriques utilisant des éléments, dits thermo électriques, permettant de générer un courant électrique en présence d'un gradient de température entre deux de leurs faces opposées selon le phénomène connu sous le nom d'effet Seebeck. Ces dispositifs comprennent un empilement de premiers tubes, destinés à la circulation des gaz d'échappement d'un moteur, et de seconds tubes, destinés à la circulation d'un fluide caloporteur d'un circuit de refroidissement. Lés éléments thermo électriques sont pris en sandwich entre les tubes de façon à être soumis à un gradient de température provenant de la différence de température entre les gaz d'échappement, chauds, et le fluide de refroidissement, froid.

Des tels dispositifs sont particulièrement intéressants car ils permettent de produire de l'électricité à partir d'une conversion de la chaleur provenant des gaz d'échappement du moteur. Ils offrent ainsi la possibilité de réduire la consommation en carburant du véhicule en venant se substituer, au moins partiellement, à l'alternateur habituellement prévu dans ceux-ci pour générer de l'électricité à partir d'une courroie entraînée par le vilebrequin du moteur.

Un inconvénient des dispositifs connus est qu'ils nécessitent qu'un très bon contact soit assuré entre les éléments thermo électriques et les tubes. Il faut ainsi disposer de tubes présentant une planéité et un état de surface impactant le coût de revient du dispositif.

Une première solution, consistant à renforcer le contact grâce à des tirants exerçant un effort sur l'empilement de tubes, a été testée. Cette solution nécessite cependant d'utiliser des tubes ne risquant pas de s'écraser sur eux-mêmes sous l'effet de cet effort, conduisant à une surconsommation de matière.

Les éléments thermo électrique connus sont en outre fragiles, en particulier aux efforts de cisaillement, et la dilatation thermique des tubes peut les endommager.

WO2009/156361 divulgue un dispositif thermo électrique comprenant un premier et second circuit pour circuler des fluides. L'invention vise à améliorer la situation en proposant un dispositif thermo électrique, comprenant un premier circuit, dit chaud, apte à permettre la circulation d'un premier fluide, et un second circuit, dit froid, apte à permettre la circulation d'un second fluide de température inférieure à celle du premier fluide, et des éléments, dits thermo électriques, permettant de générer un courant électrique en présence d'un gradient de température.

Selon l'invention, il comprend des ailettes en relation d'échange thermique avec ledit circuit chaud et/ou ledit circuit froid, lesdits éléments thermo électriques étant en contact au moins avec lesdites ailettes.

En associant les éléments thermo électriques à des ailettes, on facilite l'intimité du contact entre ceux-ci et les composants, chauds et/ou froids, du dispositif au contact desquels ils doivent se trouver pour être soumis à un gradient de température. En effet, l'obligation d'établir une liaison étroite entre les éléments thermo électriques et le ou les composants créant le gradient de température nécessaire à leur fonctionnement n'est plus portée par les tubes de circulation de fluide mais par un composant spécifique, les ailettes, qui peut donc être choisie pour cela, au moins pour l'un desdits circuits chaud ou froid. Les solutions techniques utilisées pour établir un pont thermique efficace entre, d'une part, les ailettes et les tubes et, d'autre part, les ailettes et les éléments thermo électriques, pourront donc être optimisées séparément.

Au moins certaines desdites ailettes sont associées par pair et un matériau compressible est prévu entre les ailettes d'une même paire. En prévoyant un matériau compressible entre les ailettes, on dispose d'une solution permettant d'absorber au niveau dudit matériau compressible le stress mécanique généré par la dilatation thermique des tubes. On évite de la sorte qu'il se propage jusqu'aux éléments thermo électriques.

Ledit matériau compressible pourra être prévu électriquement isolant. Les éléments thermo électriques pourront, pour une première partie, être d'un premier type, dit P, permettant d'établir une différence de potentiel électrique dans un sens, dit positif, lorsqu'ils sont soumis à un gradient de température donné, et, pour l'autre partie, être d'un second type, dit N, permettant la création d'une différence de potentiel électrique dans un sens opposé, dit négatif, lorsqu'ils sont soumis au même gradient de température.

Selon un premier mode de réalisation:
- le circuit chaud comprend des tubes, dits chauds, pour la circulation du fluide chaud,
- ledit circuit froid comprend des tubes, dits froids, pour la circulation du fluide froid,
- lesdites ailettes sont en relation d'échange thermique avec les tubes froids,
- les éléments thermo électriques sont en relation d'échange thermique, d'une part, avec les tubes chauds et, d'autre part avec les ailettes froides,
- lesdites ailettes froides sont groupées par paire, ledit matériau compressible étant prévu entre les ailettes d'une même paire.

Selon un second mode de réalisation :
- ledit circuit chaud comprend des tubes, dits chaud, pour la circulation du fluide chaud,
- ledit circuit froid comprend des tubes, dits froids, pour la circulation du fluide froid,
- pour une première partie, lesdites ailettes, dites froides, sont en relation d'échange thermique avec lesdits tubes froids,
- pour l'autre partie, lesdites ailettes, dites chaudes, sont en relation d'échange thermique avec lesdits tubes chauds,
- lesdits éléments thermoélectriques sont prévus en relation d'échange thermique, d'une part, avec les ailettes froides et, d'autre part, avec les ailettes chaudes.

Lesdits tubes froids et lesdits tubes chauds s'étendent, par exemple, selon une même direction, dite Y, et les ailettes chaudes et les ailettes froides sont disposés parallèlement les unes aux autres dans des plans, orthogonaux à la direction Y, les ailettes s'étendant selon une première direction, dite Z, et selon une seconde direction, dite X.

Selon un premier exemple de mise en oeuvre de ce second mode de réalisation, seules les ailettes froides sont groupées par paire, dite paire froide, et ledit matériau compressible est prévu entre les ailettes d'une même paire pour les paires froides.

Selon ce premier exemple de mise en oeuvre:
- les paires froides alternent avec les ailettes chaudes selon la direction Y de façon à ce qu'au moins une dite paire froide soit située de part et d'autre d'une dite ailette chaude, ladite ailette chaude étant prévue face à une ailette froide, de la ou des paires froides, dites amont, situées d'une part de ladite ailette chaude, ladite ailette chaude faisant également face à une ailette froide de la ou des autres paires froides, dites aval, situées de l'autre part de ladite ailette chaude,
- il est prévu au moins deux paires froides dans le prolongement l'une de l'autre selon la direction X et électriquement isolées l'une de l'autre,
- on adopte la configuration suivante :
   - un ou plusieurs éléments de type P sont prévus entre ladite ailette chaude et l'ailette froide, située en vis-à-vis, d'une première des paires froides amonts, dite première paire froide amont,
   - un ou plusieurs éléments de type N sont prévus entre ladite ailette chaude et l'ailette froide, située en vis-à-vis, d'une autre, dite seconde paire froide amont, des paires froides amont, située dans le prolongement de ladite première paire froide amont,
   - un ou plusieurs éléments de type P sont prévus entre l'ailette chaude et l'ailette froide, située en vis-à-vis, d'une première des paires froides aval, dite première paire froide aval,
   - un ou plusieurs éléments de type N sont prévus entre l'ailette chaude et l'ailette froide, située en vis-à-vis, d'une autre, dite seconde paire froide aval, des paires froides aval, située dans le prolongement de ladite première paire froide aval,
   - les éléments thermo électriques de type P, respectivement de type N, se faisant face de part et d'autre de l'ailette chaude.

Plus précisément, ou pourra prévoir que:
- l'ailette froide de la seconde paire froide amont et l'ailette froide de la seconde paire froide aval sont au même potentiel, et
- l'ailette froide de la première paire froide amont et l'ailette froide de la première paire froide aval sont au même potentiel.

On pourra encore prévoir que les ailettes des premières paires froides amont et aval d'une desdites ailettes chaudes sont mises au même potentiel que celles associées aux ailettes chaudes suivantes, selon la direction Y. De même pour les ailettes froides des secondes paires amont et aval.

Selon un second exemple de réalisation du second mode de mise en oeuvres, les ailettes froides et les ailettes chaudes sont groupées par paire, dite respectivement paire froide/paire chaude, et ledit matériau compressible est prévu entre les ailettes d'une même paire pour les paires froides et les paires chaudes.

Les paires chaudes et les paires froides sont, par exemple, alternées selon la direction Y de façon à ce qu'au moins une dite paire froide soit située de part et d'autre d'une dite paire chaude, une ailette chaude de ladite paire chaude étant prévue face à une ailette froide, de la ou des paires froides, dite amont, situées d'une part de ladite paire chaude, l'autre ailette de la même paire chaude faisant face à une ailette froide de la ou des autres paires, dite aval, desdites paires froides situées de l'autre part de ladite paire chaude.

Il pourra être prévu, notamment, au moins deux paires froides dans le prolongement l'une de l'autre selon la direction X et électriquement isolées l'une de l'autre, formant une série d'ailettes froides selon la direction X.

On adopte, par exemple, la configuration suivante :
- un ou plusieurs éléments de type P sont prévus entre une première des ailettes chaudes d'une dite paire chaudes et l'ailette froide, située en vis-à-vis, d'une première des paires froides amonts, dite première paire froide amont,
- un ou plusieurs éléments de type N sont prévus entre ladite première des ailettes chaudes et l'ailette froide, située en vis-à-vis, d'une autre, dite seconde paire froide amont, des paires froides amont, située dans le prolongement de ladite première paire froide amont,
- un ou plusieurs éléments de type N sont prévus entre l'autre ailette chaude de ladite paire chaude et l'ailette froide, située en vis-à-vis, d'une première des paires froides avals, dite première paire froide aval,
- un ou plusieurs éléments de type P sont prévus entre ladite autre ailette chaude de ladite paire chaude et l'ailette froide, située en vis-à-vis, d'une autre, dite seconde paire froide aval, des paires froides aval, située dans le prolongement de ladite première paire froide aval,
- les éléments thermo électriques de type P faisant face à des éléments thermo électriques de type N de part et d'autre de la paire chaude.

Plus précisément, on pourra prévoir une pluralité de paires chaudes dans le prolongement l'une de l'autre selon la direction X et électriquement isolées l'une de l'autre, formant une série de paires chaudes selon la direction X. Lesdites paires chaudes pourront également être réparties par rang dans lesquels elles se succèdent les unes par rapport aux autres selon la direction Y.

Les paires froides pourront aussi être réparties par rang dans lesquels elles se succèdent les unes par rapport aux autres selon la direction Y. On peut alors disposer de paires chaudes et de paires froides distribuées en quinconce.

Les tubes chauds, respectivement les tubes froids, sont, par exemple, regroupés par rangs s'étendant dans des plans orthogonaux à la direction X.

Les tube chauds pourront être prévus entre deux rangs, selon la direction Y, de paires froides et/ou les tubes froids pourront être prévus entre deux rangs, selon la direction Y, de paires chaudes.

Par ailleurs, toujours selon cet exemple de réalisation :
- l'ailette froide de la seconde paire froide amont et l'ailette froide de la seconde paire froide aval sont mises au même potentiel, pour les ailettes des paires froides se trouvant à une première extrémité des séries de paires froides,
- l'ailette froide de la première paire froide aval de l'une des paires chaudes est mise au même potentiel que l'ailette froide de ladite première paire froide amont de la paire chaude suivante dans la direction Y, lesdites ailettes froides faisant partie de la même paire d'ailette froide, pour les ailettes des paires froides se trouvant à l'autre extrémité des séries de paires froides.

Les ailettes des paires froides pourront présenter le long de l'un et/ou l'autre de leurs côtés longitudinaux un bord plié permettant d'isoler thermiquement le reste de l'ailette d'une radiation de chaleur depuis les tubes chauds en vis-à-vis.

Le dispositif conforme à l'invention comprend en outre, notamment, des boîtes collectrices pour le fluide chaud dans lequel les tubes chauds débouchent par leurs extrémités.

Les tubes froids et les tubes chauds pourront être répartis en rangs s'étendant dans des plans orthogonaux à la direction Z et les tubes froids d'un même rang orthogonal à Z sont reliés deux à deux par des conduits coudés de façon à définir une circulation du fluide froid en serpentin dans ledit rang orthogonal à Z.

Les extrémités des serpentins sont reliées de part et d'autres à une boîte collectrice dans laquelle ils débouchent.

L'invention sera mieux comprise à la lumière de la description suivante qui n'est donnée qu'à titre indicatif et qui n'a pas pour but de la limiter, accompagnée des dessins joints parmi lesquels :
- la figure 1 illustre de façon schématique, une vue de coupe partielle d'un exemple de réalisation du dispositif selon l'invention, la coupe étant réalisée selon un plan orthogonale à l'axe longitudinale des ailettes,
- la figure 2 reprend la figure 1 dans une variante de réalisation,
- la figure 3 illustre une version simplifiée du dispositif de la figure 1, les tubes chauds et les tubes froids étant par ailleurs inversés,
- la figure 4 reprend la figure 3 dans une variante de réalisation,
- la figure 5 est une vue en perspective du dispositif illustré à la figure 1.

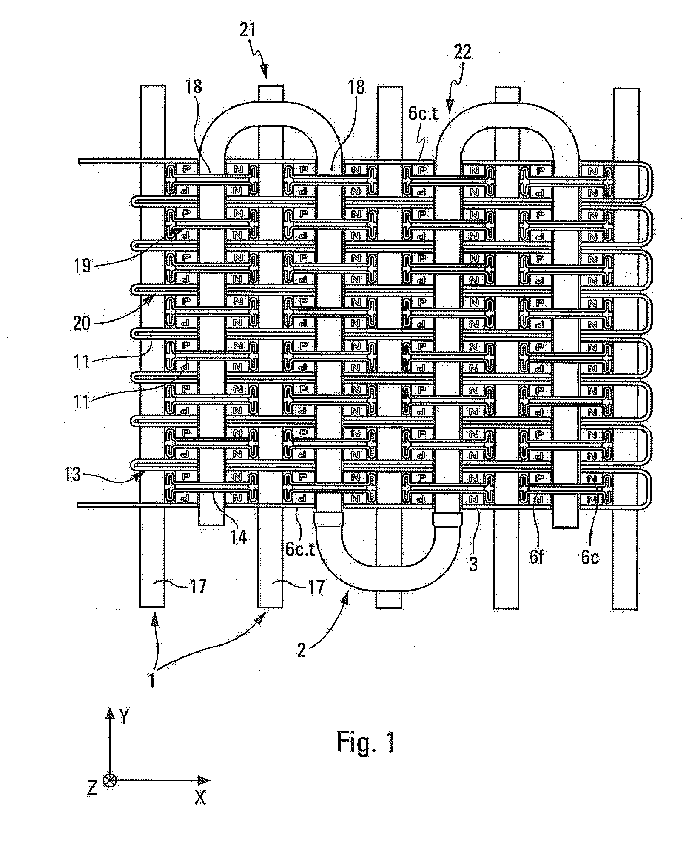

Comme illustré aux figures 1 à 4, l'invention concerne un dispositif thermo électrique, comprenant un premier circuit 1, dit chaud, apte à permettre la circulation d'un premier fluide, notamment des gaz d'échappement d'un moteur, et un second circuit 2, dit froid, apte à permettre la circulation d'un second fluide, notamment un fluide caloporteur d'un circuit de refroidissement, de température inférieure à celle du premier fluide.

Le dispositif comprend également des éléments 3, 3p, 3n, dits thermo électriques, permettant de générer un courant électrique en présence d'un gradient de température.

Il s'agit, par exemple, d'éléments de forme sensiblement parallélépipédiques générant un courant électrique, selon l'effet Seebeck, lorsqu'ils sont soumis audit gradient entre deux de leurs faces opposées 4a, 4b, dites faces actives. De tels éléments permettent la création d'un courant électrique dans une charge connectée entre lesdites faces actives 4a, 4b. De façon connue de l'homme du métier, de tels éléments sont constitués, par exemple, de Bismuth et de Tellurium (Bi₂Te₃).

Les éléments thermo électriques sont, pour une première partie, des éléments 3p d'un premier type, dit P, permettant d'établir une différence de potentiel électrique dans un sens, dit positif, lorsqu'ils sont soumis à un gradient de température donné, et, pour l'autre partie, des éléments 3n d'un second type, dit N, permettant la création d'une différence de potentiel électrique dans un sens opposé, dit négatif, lorsqu'ils sont soumis au même gradient de température.

Le dispositif comprend encore des ailettes 5f, 6c, 6f en relation d'échange thermique avec ledit circuit chaud et/ou ledit circuit froid. Un gradient de température est ainsi assuré entre lesdites ailettes ou entre les ailettes en relation d'échange thermique avec l'un desdits circuits et l'autre circuit. Lesdites ailettes 5f, 6c, 6f sont également en contact avec les éléments thermo électriques 3p, 3n au niveau, notamment, de leur face active 4a, 4b. Autrement dit les éléments thermo électriques sont disposés soit entre deux ailettes, soit entre l'une des ailettes en relation d'échange thermique avec l'un des circuits et l'autre circuit. On assure ainsi une génération de courant par les éléments thermo électriques 3, 3p, 3n.

Selon l'invention, ce sont donc les ailettes 5f, 6c, 6f qui remplissent la fonction d'établissement du contact thermique avec les éléments thermo électriques, au moins pour l'un des circuits.

Par ailette, on entend un élément présentant deux grandes surfaces 7a, 7b opposées planes et d'épaisseur très inférieure à sa largeur et à sa longueur, permettant d'établir un contact surfacique, par exemple, entre l'une desdites grandes surfaces 7a et les éléments thermo électrique 3p, 3n au niveau de la ou de leurs faces opposées 4a, 4b à soumettre à un gradient de température pour générer un courant électrique. Les ailettes 5f, 6c, 6f sont formées dans un matériau conducteur de la chaleur, notamment un matériau métallique tel que du cuivre ou de l'aluminium.

Au moins certaines desdites ailettes 5f, 6c, 6f sont associées par paire, un matériau compressible 11 étant prévu entre les ailettes d'une même paire. On peut ainsi assurer une absorption du stress mécanique généré par la dilatation des circuits chaud et/ou froid au niveau dudit matériau.

Dans chaque paire, les ailettes 5f, 6c, 6f sont, par exemple, de dimension identiques et disposées parallèlement l'une à l'autre, l'une des grandes faces 7b de l'une des ailettes 5 étant disposée en vis-à-vis d'une des grandes faces 7b de l'autre des ailettes de la paire.

Dans un premier mode de réalisation les ailettes sont revêtues d'un matériau électriquement isolant et sont munis, au niveau de leur face située en vis-en-vis des éléments thermo électriques d'une ou plusieurs pistes électriquement conductrices, non-représentées, reliant, en série et/ou en parallèle, les éléments thermo-conducteurs disposés sur l'ailette.

Selon un autre mode de réalisation, les ailettes 5f, 6c, 6f contribuent à la conduction de l'électricité produite par les éléments thermo électriques 3, 3p, 3n.

Ledit matériau compressible 11 pourra être électriquement isolant, en particulier dans le mode de réalisation évoqué au paragraphe précédent.

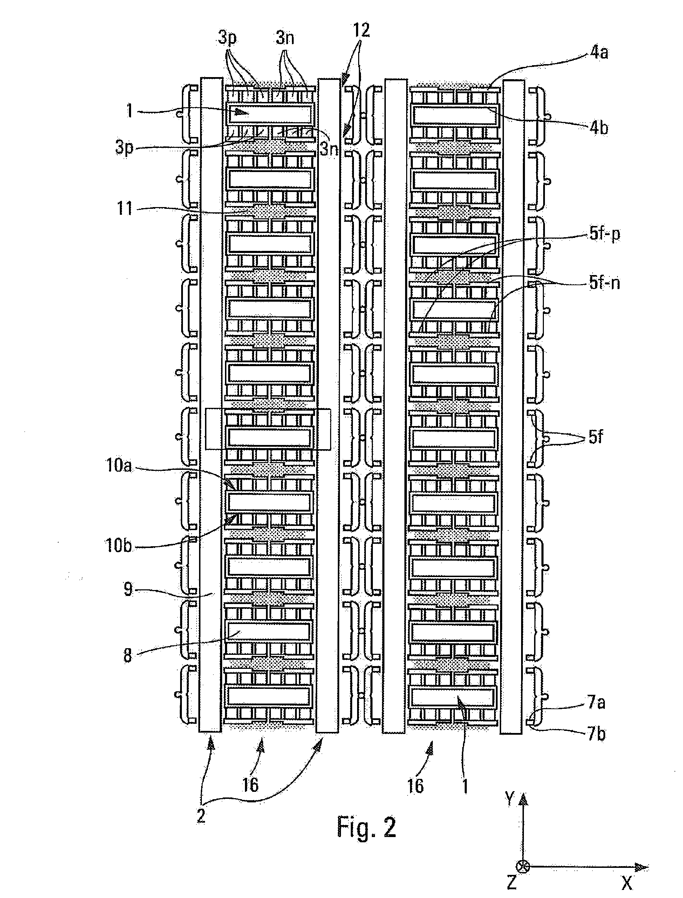

Si l'on se reporte maintenant plus précisément au mode de réalisation de la figure 2, on constate que le circuit chaud comprend des tubes 8, dits chauds, pour la circulation du fluide chaud. Quant au circuit froid, il comprend des tubes 9, dits froids, pour la circulation du fluide froid. Les ailettes 5f, dites froides, sont prévues en relation d'échange thermique avec les tubes froids 9. Et les éléments thermo électriques 3p, 3n sont en relation d'échange thermique, d'une part, avec les tubes chauds 8 et, d'autre part avec les ailettes froides 5f. Lesdites ailettes froides 5f sont groupées par paire, ledit matériau compressible 11 étant prévu entre les ailettes d'une même paire.

Lesdits tubes chauds 8 sont, par exemple, des tubes sensiblement plats comprenant deux grandes faces opposées parallèles 10a, 10b sur laquelle sont disposés les éléments thermo électriques 3p, 3n par l'une de lieur face active 4a, 4b. Ils sont configurés pour permettre la circulation de gaz d'échappement et sont, notamment, en acier inoxydable. Ils sont formés, par exemple, par profilage, soudage et/ou brasage. Ils pourront présenter une pluralité de canaux de passage du premier fluide, séparés par des cloisons reliant les faces planes opposées des tubes.

Les tubes chauds 8 sont revêtus au niveau desdites grandes faces 10a, 10b d'une couche de matériau électriquement isolant et sont munies de pistes électriquement conductrices reliant, en série et/ou en parallèle, tout ou partie des éléments thermo-conducteurs disposés sur les tubes chauds 8.

Les ailettes froides 5f présentent, par exemple, des orifices 12 pour le passage des tubes froids 9. Lesdits tubes froids sont, par exemple, en aluminium ou en cuivre et présentent une section ronde et/ou oval.

Le contact entre les tubes 9 et les ailettes froides 5f est réalisé, par exemple, par une expansion de la matière des tubes comme dans les échangeurs de chaleur connus sous le nom d'échangeurs mécaniques dans le domaine des échangeurs de chaleur pour les véhicules automobile. Dans les modes de réalisation où la conduction d'électricité est réalisée par les ailettes, un isolant électrique est prévu entre les tubes froids 9 et les ailettes froides 5f.

Selon le mode de réalisation illustré, à chaque face plane 10a, 10b des tubes chauds 8 sont associées au moins deux dites ailettes froides 5f-p, 5f-n, dites voisines, prévues en vis-à-vis de ladite face plane et électriquement isolée l'une de l'autre. Les éléments thermoélectriques prévus entre une première 5f-p desdites ailettes voisines, dite ailette de type P, et l'une desdites faces planes, sont de type P et les éléments thermoélectriques prévus entre l'autre 5f-n desdites deux ailettes, dite ailette de type N, et ladite face plane sont de type N, de façon à créer une différence de potentiel entre lesdites deux ailettes voisines 5f-p, 5f-n.

Ce sous-ensemble constitué d'une ailette froide 5f-p, d'un ou plusieurs éléments thermo électrique de type P, d'une face 10a ou 10b du tube chaud 8, d'un ou plusieurs thermo élément de type N et d'une ailette froide 5f-n définit une brique de base qui pourra être reproduite, les briques étant alors assemblées électriquement en parallèle et/ou en série de différente façon pour permettre la génération d'un courant présentant l'intensité et/ou la différence de potentiel voulues.

Il est à noter que, dans cette brique de base, en variante, l'ailette froide 5f-p en relation avec les éléments thermo électriques de type P et l'ailette froide 5f-n en relation avec les éléments thermo électriques de type N pourront être constituées d'une seule et même ailette froide, portant des pistes de conduction du courant pour éviter tout court-circuit entre la partie de l'ailette froide en relation avec les éléments thermo électriques de type P et la partie de l'ailette froide en relation avec les éléments thermo électriques de type N.

Nous allons maintenant décrire un exemple de réalisation de disposition des éléments thermo électriques 3p, 3n vis-à-vis d'un tube chaud 8 donné et des ailettes froides 5f prévus en correspondance, réalisant une premier assemblage de la brique de base évoqué plus haut.

Des ailettes 5f-p de type P, respectivement 5f-n de type N, se trouvent, par exemple, de part et d'autre d'un même tube chaud 9 et sont électriquement connectées entre elles de façon, notamment, à associer en parallèle les éléments thermo électriques se trouvant de part et d'autre du tube chaud 9.

Lesdits tubes chauds sont superposés dans une première direction orthogonale Y aux ailettes 5f en un ou plusieurs rangs 16, lesdits tubes chauds 8 d'un rang étant disposés entre deux tubes froids 9. Lesdits tubes froids 9 sont orientés selon la direction Y d'empilement des tubes chauds 8.

Les tubes chauds 8 de chaque rang 16 sont, par exemple, prévus dans le prolongement les uns des autres d'un rang 16 à l'autre. Les éléments thermo électriques des tubes chauds 8 se trouvant dans le prolongement l'un de l'autre sont, par exemple, connectés en série d'un rang 16 à l'autre. Autrement dit, les ailettes 5f-p, 5f-n se trouvant de part et d'autre d'un même tube chaud 8, d'un côté dudit tube, et les ailettes 5f-p, 5f-n du tube chaud 8 se trouvant dans le prolongement du premier dans le rang de tubes chauds 8 voisins sont mises au même potentiel.

Si l'on se reporte à nouveau à la figure 1, selon le mode de réalisation illustré, ledit circuit chaud comprend des tubes 17, dits chaud, pour la circulation du fluide chaud et ledit circuit froid comprend des tubes 18, dits froids, pour la circulation du fluide froid. Il s'agit, notamment, de tubes ronds et/ou ovales, par exemple en acier inoxydable pour les tubes chauds 17 et en aluminium ou en cuivre pour les tubes froids 18.

Pour une première partie, lesdites ailettes 6f, dites froides, sont en relation d'échange thermique avec lesdits tubes froids 18 et, pour l'autre partie, lesdites ailettes 6c, dites chaudes, sont en relation d'échange thermique avec lesdits tubes chauds 17.

Lesdits éléments thermoélectriques 3 sont prévus en relation d'échange thermique, d'une part, avec les ailettes froides 6f et, d'autre part, avec les ailettes chaudes 6c.

De même que dans les ailettes froides 5f du mode de réalisation précédent, il est prévu des orifices de passages 13, 14 pour les tubes chauds 17, respectivement froids 18, dans les ailettes chaudes 6c, respectivement froides 6f. Le contact tube/ailette est, notamment, de type mécanique, tel qu'évoqué plus haut. Dans les modes de réalisation où la conduction d'électricité est réalisée par les ailettes, un isolant électrique est prévu entre les tubes 17, 18 et les ailettes 6f, 6c.

Selon le mode de réalisation illustré, lesdits tubes froids 18 et lesdits tubes chauds 17 s'étendent selon une même direction, dite Y, et les ailettes chaudes et les ailettes froides sont disposées parallèlement les unes aux autres dans des plans, orthogonaux à la direction Y, les ailettes s'étendant selon une première direction, dite Z, et selon une seconde direction, dite X.

Selon un premier exemple de mise en oeuvre, correspondant aux figures 1, 3 et 5, les ailettes froides 6f et les ailettes chaudes 6c sont groupées par paire, dite respectivement paire froide 19 / paire chaude 20, et ledit matériau compressible 11 est prévu entre les ailettes 6f, 6c d'une même paire pour les paires froides et les paires chaudes.

Les paires chaudes et les paires froides sont alternées selon la direction Y de façon à ce qu'au moins une dite paire froide soit située de part et d'autre d'une dite paire chaude.

Il est prévu au moins deux paires froides dans le prolongement l'une de l'autre selon la direction X et électriquement isolées l'une de l'autre, formant un rang d'ailettes froides selon la direction X.

Comme dans le mode de réalisation précédent, on retrouve ici un motif formé par un assemblage d'ailettes froides 6f et d'ailette chaudes 6c, séparées ou non par le matériau compressible 11, et de thermo éléments 3p, 3n. Nous allons décrire dans la suite différentes constitutions possibles de ce motif et différentes façon possibles d'assembler les motifs, notamment d'un point de vue électrique.

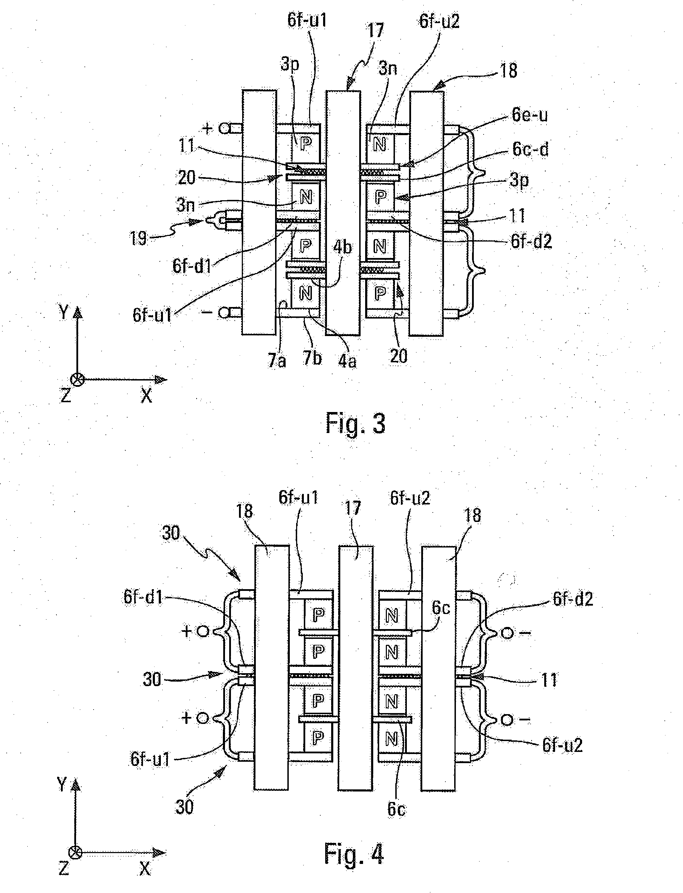

Comme détaillé figure 3, selon un premier exemple de réalisation dudit motif, une première des ailettes chaudes 6c-u de ladite paire chaude 20 est prévue face à deux ailettes froides 6f-u1, 6f-u2, de paires froides distincts, dites première et deuxième paires froides amont, situées dans le prolongement l'une de l'autre, d'une part de ladite paire chaude 20, l'autre ailette 6c-d de la même paire chaude 20 faisant face à deux ailettes froides 6f-d1, 6f-d2 de paires froides distincts, dites première et deuxième paire froide aval, situées dans le prolongement l'une de l'autre, de l'autre part de ladite paire chaude 20.

Un ou plusieurs éléments de type P sont prévus entre la première 6c-u des ailettes chaudes et l'ailette 6f-u1 de la première paires froides amont. Un ou plusieurs éléments de type N sont prévus entre ladite première des ailettes chaudes 6c-u et l'ailette froide 6f-u2 de la seconde paire froide amont.

Un ou plusieurs éléments de type P sont prévus entre l'autre ailette chaude 6c-d de ladite paire chaude 20 et l'ailette froide 6f-d2 de la seconde paire aval. Un ou plusieurs éléments de type N sont prévus entre ladite autre ailette chaude 6c-d de ladite paire chaude 20 et l'ailette froide 6f-d1 de la première paire aval. De part et d'autre de la paire chaude 20, les éléments de type P amont font face à des éléments de type N aval et les éléments de type N amont font face à des éléments de type P aval.

En se reportant de nouveau à la figure 1 où les tubes chauds 17 et les tubes froids 18 sont inversés par rapport à la figure 3, on constate que le dispositif conforme à l'invention pourra comprendre, selon cet exemple de mise en oeuvre, une pluralité de paires chaudes 20 situés dans le prolongement l'une de l'autre selon la direction X et électriquement isolées l'une de l'autre, de façon à former une série de paires chaudes selon la direction X.

Lesdites paires chaudes sont également répartis par rang dans lesquels elles se succèdent les unes par rapport aux autres selon la direction Y.

Autrement dit, lesdites séries et lesdits rangs de paires chaudes se succèdent selon les directions X et Y.

Les paires froides 19 sont aussi réparties par rang dans lesquels elles se succèdent les unes par rapport aux autres selon la direction Y et/ou en série selon la direction X. Les paires chaudes 20 et les paires froides 19 sont, par exemple, prévues en quinconce.

Les tube chauds 17 sont prévus, par exemple, entre deux rangs de paires froides 19, selon la direction Y, et/ou les tubes froids 18 sont prévus entre deux rangs de paires chaudes 20, selon la direction Y.

La succession de paire chaudes 20 et/ou froide 19 selon la direction Y pourra se terminer de part et d'autre, notamment, par une ailette chaude 6c-t, prévue seule, plutôt qu'en paire.

Les ailettes 6c, 6f s'étendent longitudinalement selon la direction Z et transversalement selon la direction X et les tubes chauds, respectivement les tubes froids, sont regroupés par rangs 21, 22 s'étendant dans des plans orthogonaux à la direction X.

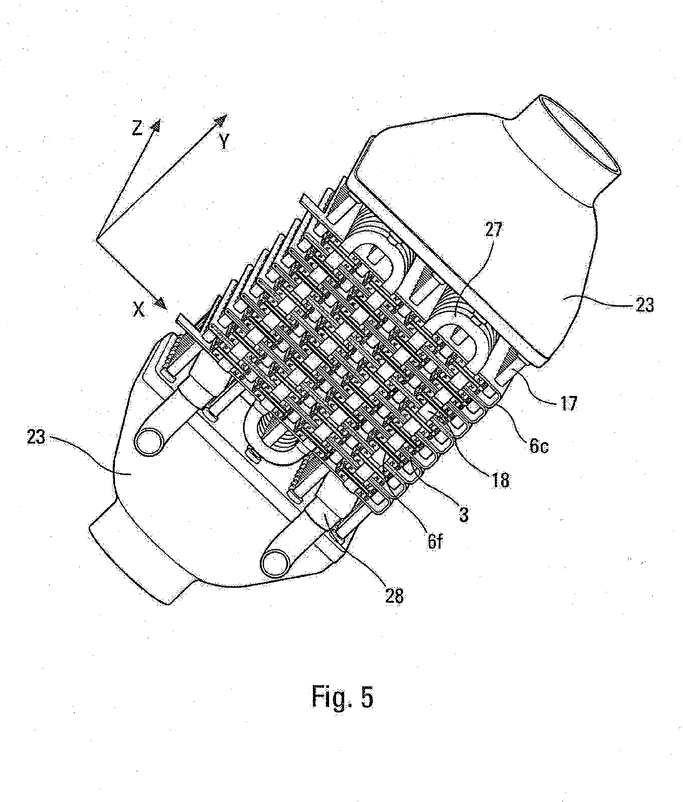

Comme illustré à la figure 5, le dispositif comprend en outre des boîtes collectrices 23 pour le fluide chaud dans lequel les tubes chauds débouchent par leurs extrémités.

Les tubes froids et/ou les tubes chauds sont également répartis en rangs s'étendant dans des plans orthogonaux à la direction Z. Les tubes froids 18 d'un même rang orthogonal à Z sont reliés deux à deux par des conduits coudés 27 reliés à leur extrémité de façon à définir une circulation du fluide froid en serpentin dans ledit rang orthogonal à Z.

Les extrémités des serpentins sont reliées de part et d'autres à une boîte collectrice 28 dans laquelle ils débouchent.

D'un point de vue électrique, des connexions entre les ailettes sont réalisés par les ailettes chaudes à la figure 1. Cela étant, on peut aussi les réaliser par les ailettes froides et, à la figure 3, on constate que le motif évoqués plus haut est assemblés de la façon suivante. Les ailettes froides 6f-u2 de la seconde pair amont d'un motif sont connectés au ailettes froides 6f-u1 de la première pair amont du motif voisin, dans la direction X. De même pour les ailettes froide aval 6f-d2, 6f-d1.

De plus, que le dispositif comporte une ou plusieurs paires chaudes :
- l'ailette froide 6f-u2 de la seconde paire froide amont et l'ailette froide 6f-d2 de la seconde paire froide aval sont mises au même potentiel, pour les ailettes des paires froides se trouvant à une première extrémité des séries de paires froides,
- l'ailette froide 6f-d1 de la première paire froide aval de l'une des paires chaudes est mise au même potentiel que l'ailette froide 6f-u1 de ladite première paire froide amont de la paire chaude suivante dans la direction Y, lesdites ailettes froides 6f-d2, 6f-u1 faisant partie de la même paire d'ailette froide, pour les ailettes des paires froides se trouvant à l'autre extrémité des séries de paires froides.

Au bornes des ailettes chaudes 6c-t, comme à la figure 1, ou froide, comme à la figure 3, se trouvant en extrémité de la succession d'ailettes selon la direction Y, on dispose ainsi d'une différence de potentiel correspondant à l'addition des différences de potentiels créer aux bornes des rangs successifs d'ailettes chaudes, respectivement froides 6f.

Selon un exemple particulier de réalisation, les ailettes des paires froides 6f présentent le long de l'un et/ou l'autre de leurs côtés longitudinaux un bord plié 29 permettant d'isoler thermiquement le reste de l'ailette d'une radiation de chaleur depuis les tubes chauds 17 en vis-à-vis.

Selon un autre exemple de mise en oeuvre, correspondant à un motif différent, illustré à la figure 4, seules les ailettes froides 6f sont groupées par paire, dite paire froide 30, et ledit matériau compressible 11 est prévu entre les ailettes d'une même paire pour les paires froides.

Dans cet exemple de mise en oeuvre, les paires froides 30 alternent avec les ailettes chaudes selon la direction Y de façon à ce qu'au moins une dite paire froide soit située de part et d'autre d'une dite ailette chaude 6c.

Il pourra être prévue au moins deux paires froides dans le prolongement l'une de l'autre selon la direction X et électriquement isolées l'une de l'autre.

Selon le motif illustré à la figure 4, ladite ailette chaude 6c est prévue, par exemple, face à deux ailettes froides 6f-u1, 6f-u2, de paires froides distincts, dites première et deuxième paires froides amont, situées dans le prolongement l'une de l'autre, prévues d'une part de ladite ailette chaude, ladite ailette chaude 6c faisant aussi face à deux ailettes froides 6f-d1, 6f-d2, de paires froides distincts, dites première et deuxième paires froide aval, situées dans le prolongement l'une de l'autre, de l'autre part de ladite ailette chaude 6c.

Un ou plusieurs éléments de type P sont prévus entre ladite ailette chaude 6c et l'ailette froide 6f-u1 de la première paire froide amont. Un ou plusieurs éléments de type N sont prévus entre ladite ailette chaude 6c et l'ailette froide 6f-u2 , de la seconde paire froide amont.

Un ou plusieurs éléments de type N sont prévus entre l'ailette chaude 6c et l'ailette froide 6f-d2, de la seconde paire froide aval. Un ou plusieurs éléments de type P sont prévus entre l'ailette chaude 6c et l'ailette froide 6f-u1 de la première paire froide aval. Les éléments de type P amont et aval sont situés face à face de part et d'autre de l'ailette chaude 6c. De même pour les éléments de type N.

Avec ce motif, on pourra utiliser les connexions électriques suivantes. L'ailette froide 6f-u2 de la seconde paire froide amont et l'ailette froide de la seconde paire froide aval 6f-d2 sont électriquement connectées de façon à être au même potentiel. De même pour l'ailette froide 6f-u1 de la première paire froide amont et l'ailette froide 6f-d1 de la première paire froide aval.

Et on pourra assembler les motifs de la façon suivante. Les ailettes 6f-d1, 6f-u1 des premières paires froides amont et aval d'une desdites ailettes chaudes 6c sont mises au même potentiel que celles associées aux ailettes chaudes suivantes, selon la direction Y. L'ailette froides des premières paires froides aval et l'ailette froide des premières paires froides amont associées à deux ailettes chaudes successives 6c, selon la direction Y, font partie de la même paire d'ailettes froides. De même pour les ailettes 6f-d2, 6f-u2 des secondes paires froides amont et aval.

Bien que cela ne soit pas représenté, on pourra prévoir un faisceau utilisant le motif de la figure 4, à plusieurs rangs de tube chauds 17, orientés selon la direction Y, à chaque fois intercalé entre deux tubes froids 18, eux aussi orienté selon la direction Y, les ailettes chaudes et froides étant orientées orthogonalement aux tubes. Pour ce qui est des connexions électriques, lesdits rangs seront, par exemple, montés en série.

Un avantage des deux modes de mise en oeuvre des figures 3 et 4 est qu'ils permettent d'éviter les ponts thermiques entre les composants chauds et les composants froids, grâce à la réalisation de sous-ensembles de tubes chauds et d'ailettes chaudes, et de sous-ensembles de tubes froids et d'ailettes froides, séparés, même s'ils sont imbriqués, les seuls contact entre ces sous-ensembles ayant lieu par l'intermédiaire des éléments thermo électriques. Autrement dit, il y a une alternance entre les éléments thermo électriques de type P et de type N selon la direction X.

Selon un exemple de mise en oeuvre encore différent, non représenté, les tubes chauds et les tubes froids sont intercalées les uns les autres tandis que des ailettes chaudes et les ailettes froides sont intercalées les unes les autres, dans des plans perpendiculaires aux tubes, les ailettes froides et/ou les ailettes chaudes étant réparties par paire, les ailettes d'une même paire étant séparées conformément à l'invention par ledit matériau compressible.

Comme dans les exemples de mises en oeuvre des figures 1 et 3 à 5, chaque ailette froide, respectivement chaude, est munie d'orifice de passage et de contact thermique avec les tubes froids, respectivement chauds.

Elles sont en outre munies d'orifices de passage sans contact ou avec un contact isolant thermiquement et électriquement avec les tubes chauds, respectivement froids.

Entre une ailette froide et un ailette chaude placées en vis-à-vis, il est prévu des éléments thermo électriques de même type. Les ailettes d'une même paire sont mises au même potentiel électrique. Les ailettes froides sont successivement connectées en série. En variante, les éléments thermo électriques situés entre deux ailettes chaude et froide voisines sont de type alterné, les ailettes étant munis de pistes de circulation de courant pour éviter les court-circuit entre les éléments thermo électriques.

Dans ce qui précède, par «électriquement connectés» ou par « mises au même potentiel », on entend que les ailettes sont connectés l'une à l'autre dans le cas où c'est elles qui conduisent l'électricité ou que les pistes prévues sur les ailettes sont connectés entre elles d'une ailette à l'autre lorsque les ailettes sont munies de pistes conductrices, par exemple à l'aide de cosses de connexion et de conducteurs électriques classiques.

A ce sujet, on peut noter que réaliser une connexion électrique par les ailettes froides plutôt que par les ailettes chaudes est avantageux car ceci ne nécessite pas de faire appel à des composants électriques dimensionnés pour résister à de fortes températures.

Un mode d'obtention du dispositif conforme à l'invention comprend une étape dans laquelle les éléments thermo électriques sont d'abord assemblés avec les composants chauds, tubes chauds 8 ou ailettes chaudes 6c, puis sont ensuite assemblés avec les ailettes froides 5f, 6f. L'avantage de procéder de façon successive, dans cette ordre, et que l'on peut utiliser des conditions d'exécution relativement sévères pour la liaison éléments thermo électriques / composants chauds et des conditions moins sévères pour la liaison éléments thermo électriques / ailettes froides, sans que cette dernière risque d'être endommagée par l'exécution de la liaison éléments thermo électriques / composants chauds.

On procède à un empilement des ailettes et, dans une étape ultérieure, les tubes froids 9, 18 sont assemblés dans les ailettes froides 5f, 6f. De même pour les tubes chauds 17 dans les ailettes chaudes 6c dans les modes de réalisations à ailettes chaudes.

Pour assurer la liaison tubes/ailettes, comme déjà évoqué plus haut, les tubes 9, 17, 18 en contact avec les ailettes sont alors soumis, par exemple, à une expansion. Il s'agit, notamment, d'une expansion radiale, obtenu par le passage d'une olive d'expansion à l'intérieur du tube, résultant en un sertissage des ailettes 5f, 6f, 6c sur les tubes.

On obtient de la sorte un faisceau dans lequel les tubes chauds 8, 17 et les tubes froids 9, 18 forment une armature grâce à la contrainte exercée par les ailettes, une fois celles-ci serties sur les tubes, sans qu'il y ait à utiliser de tirants, de serrage. Les tubes sont ensuite reliés à des boîtes collectrices. Les ailettes sont électriquement reliées entre elles selon les différents schémas évoqués plus haut.

Selon un mode de réalisation, le matériau compressible est maintenu comprimé. Pour cela, on pourra, par exemple, le maintenir en compression avant l'expansion des tubes froids et/ou chauds, par des moyens externes qui pourront être retirés après expansion. Grâce à la contrainte exercée par les ailettes, ledit matériau compressible reste précontraint.

## Revendications

1. Dispositif thermo électrique, comprenant un premier circuit (1), dit chaud, apte à permettre la circulation d'un premier fluide, et un second circuit (2), dit froid, apte à permettre la circulation d'un second fluide de température inférieure à celle du premier fluide, et des éléments (3, 3p, 3n), dits thermo électriques, permettant de générer un courant électrique en présence d'un gradient de température, **caractérisé en ce qu'**il comprend des ailettes (5f, 6f, 6c) en relation d'échange thermique avec ledit circuit chaud (1) et/ou ledit circuit froid (2), les éléments thermo électriques (3, 3p, 3n) étant en contact au moins avec lesdites ailettes (5f, 6f, 6c), au moins certaines desdites ailettes (5f, 6f, 6c), étant associées par pair, un matériau compressible (11) étant prévu entre les ailettes (5f, 6f, 6c) d'une même paire.

2. Dispositif selon la revendication 1 dans lequel ledit matériau compressible (11) est prévu électriquement isolant.

3. Dispositif selon la revendication 1 ou 2 dans lequel les éléments thermo électriques sont pour, une première partie (3p), d'un premier type, dit P, permettant d'établir une différence de potentiel électrique dans un sens, dit positif, lorsqu'ils sont soumis à un gradient de température donné, et, pour l'autre partie (3n), d'un second type, dit N, permettant la création d'une différence de potentiel électrique dans un sens opposé, dit négatif, lorsqu'ils sont soumis au même gradient de température.

4. Dispositif selon la revendication 3 dans lequel:
- le circuit chaud comprend des tubes (8), dits chauds, pour la circulation du fluide chaud,
- ledit circuit froid comprend des tubes (9), dits froids, pour la circulation du fluide froid,
- lesdites ailettes (5f), dites froides, sont en relation d'échange thermique avec les tubes froids (9),
- les éléments thermo électriques (3p, 3n) sont en relation d'échange thermique, d'une part, avec les tubes chauds (8) et, d'autre part avec les ailettes froides (5f),
- lesdites ailettes froides 5f sont groupées par paire, ledit matériau compressible (11) étant prévu entre les ailettes d'une même paire.

5. Dispositif selon la revendication 3 dans lequel :
- ledit circuit chaud comprend des tubes (17), dits chaud, pour la circulation du fluide chaud,
- ledit circuit froid comprend des tubes (18), dits froids, pour la circulation du fluide froid,
- pour une première partie (6f), lesdites ailettes, dites froides, sont en relation d'échange thermique avec lesdits tubes froid (18),
- pour l'autre partie (6c), lesdites ailettes, dites chaudes, sont en relation d'échange thermique avec lesdits tubes chauds (17),
- lesdits éléments thermoélectriques (3p, 3n) sont prévus en relation d'échange thermique, d'une part, avec les ailettes froides (6f) et, d'autre part, avec les ailettes chaudes (6c).

6. Dispositif selon la revendication 5 dans lequel lesdits tubes froids (17) et lesdits tubes chauds (18) s'étendent selon une même direction, dite Y, et les ailettes chaudes (6c) et les ailettes froides (6f) sont disposés parallèlement les unes aux autres dans des plans, orthogonaux à la direction Y, les ailettes (6f, 6c) s'étendant selon une première direction, dite Z, et selon une seconde direction, dite X.

7. Dispositif selon la revendication 6 dans lequel seules les ailettes froides (6f) sont groupées par paire (30), dite paire froide, et ledit matériau compressible (11) est prévu entre les ailettes (6f) d'une même paire pour les paires froides (30).

8. Dispositif selon la revendication 7 dans lequel les paires froides (30) alternent avec les ailettes chaudes (6c) selon la direction Y de façon à ce qu'au moins une dite paire froide (30) soit située de part et d'autre d'une dite ailette chaude (6c), ladite ailette chaude étant prévue face à une ailette froide (6f), de la ou des paires froides (30), dites amont, situées d'une part de ladite ailette chaude (6c), ladite ailette chaude (6c) faisant également face à une ailette froide (6f) de la ou des autres paires froides (30), dites aval, situées de l'autre part de ladite ailette chaude (6c).

9. Dispositif selon la revendication 8 dans lequel il est prévu au moins deux paires froides (30) dans le prolongement l'une de l'autre selon la direction X et électriquement isolées l'une de l'autre.

10. Dispositif selon la revendication 9 dans lequel :
- un ou plusieurs éléments (3p) de type P sont prévus entre ladite ailette chaude (6c) et l'ailette froide (6f-u1), située en vis-à-vis, d'une première des paires froides (30) amont, dite première paire froide amont,
- un ou plusieurs éléments (3n) de type N sont prévus entre ladite ailette chaude et l'ailette froide (6f-u2), située en vis-à-vis, d'une autre, dite seconde paire froide amont, des paires froides (30) amont, située dans le prolongement de ladite première paire froide amont,
- un ou plusieurs éléments (3p) de type P sont prévus entre l'ailette chaude (6c) et l'ailette froide 6f-d1, située en vis-à-vis, d'une première des paires froides (30) avals, dite première paire froide aval,
- un ou plusieurs éléments (3n) de type N sont prévus entre l'ailette chaude (6c) et l'ailette froide (6f-d2), située en vis-à-vis, d'une autre, dite seconde paire froide aval, des paires froides (30) aval, située dans le prolongement de ladite première paire froide aval,
- les éléments thermo électriques (3p) de type P, respectivement (3n) de type N, se faisant face de part et d'autre de l'ailette chaude (6c).

11. Dispositif selon la revendication 10 dans lequel :
- l'ailette froide (6f-u2) de la seconde paire froide amont et l'ailette froide (6f-d2) de la seconde paire froide aval sont mises au même potentiel, et
- l'ailette froide (6f-u1) de la première paire froide amont et l'ailette froide (6f-d1) de la première paire froide aval sont mises au même potentiel.

12. Dispositif selon la revendication 11 dans lequel :
- les ailettes (6f-u1, 6f-d1) des premières paires froides amont et aval d'une desdites ailettes chaudes (6c) sont mises au même potentiel que celles associées aux ailettes chaudes 6c suivantes, selon la direction Y,
- les ailettes (6f-u2, 6f-d2) des secondes paires froides amont et aval d'une desdites ailettes chaudes (6c) sont mises au même potentiel que celles associées aux ailettes chaudes (6c) suivantes, selon la direction Y.

13. Dispositif selon la revendication 6 dans lequel les ailettes froides (6f) et les ailettes chaudes (6c) sont groupées par paire, dite respectivement paire froide (19), paire chaude (20), et ledit matériau compressible (11) est prévu entre les ailettes (6f, 6c) d'une même paire pour les paires froides (19) et les paires chaudes (20).

14. Dispositif selon la revendication 13 dans lequel les paires chaudes (20) et les paires froides (19) sont alternées selon la direction Y de façon à ce qu'au moins une dite paire froide (19) soit située de part et d'autre d'une dite paire chaude (20), une ailette chaude (6c-u) de ladite paire chaude étant prévue face à une ailette froide, de la ou des paires froides (19), dite amont, situées d'une part de ladite paire chaude (20), l'autre ailette (6c-d) de la même paire chaude (20) faisant face à une ailette froide de la ou des autres paires, dite aval, desdites paires froides (19) situées de l'autre part de ladite paire chaude (20).

15. Dispositif selon la revendication 14 dans lequel il est prévu au moins deux paires froides (19) dans le prolongement l'une de l'autre selon la direction X et électriquement isolées l'une de l'autre, formant un rang d'ailettes froides selon la direction X.

16. Dispositif selon la revendication 15 dans lequel :
- un ou plusieurs éléments (3p) de type P sont prévus entre une première (6c-u) des ailettes chaudes d'une dite paire chaudes et l'ailette froide (6f-u1), située en vis-à-vis, d'une première des paires froides amonts, dite première paire froide amont,
- un ou plusieurs éléments de type N sont prévus entre ladite première des ailettes chaudes (6c-u) et l'ailette froide (6f-u2), située en vis-à-vis, d'une autre, dite seconde paire froide amont, des paires froides amont, située dans le prolongement de ladite première paire froide amont,
- un élément (3n) de type N sont prévus entre l'autre ailette chaude (6c-d) de ladite paire chaude et l'ailette froide (6f-u1), située en vis-à-vis, d'une première des paires froides avals, dite première paire froide aval,
- un élément (3p) de type P sont prévus entre ladite autre ailette chaude (6c-d) de ladite paire chaude et l'ailette froide (6f-u2), située en vis-à-vis, d'une autre, dite seconde paire froide aval, des paires froides aval, située dans le prolongement de ladite première paire froide aval,
- les éléments thermo électriques (3p) de type P faisant face à des éléments thermo électriques (3n) de type N de part et d'autre de la paire chaude (20).

17. Dispositif selon la revendication 16 comprenant une pluralité de paires chaudes (20) dans le prolongement l'une de l'autre selon la direction X et électriquement isolées l'une de l'autre de façon, formant une série de paires chaudes selon la direction X.

18. Dispositif selon la revendication 17 dans lesquels lesdites paires chaudes (20) sont également réparties par rang dans lesquels elles se succèdent les unes par rapport aux autres selon la direction Y.

19. Dispositif selon la revendication 18 dans lequel les paires froides sont également réparties par rang dans lesquels elles se succèdent les unes par rapport aux autres selon la direction Y, les paires chaudes et les paires froides étant prévues en quinconce.

20. Dispositif selon la revendication 19 dans lequel les tubes chauds (17), respectivement les tubes froids (18), sont regroupés par rangs s'étendant dans des plans orthogonaux à la direction X.

21. Dispositif selon la revendication 20 dans lequel les tube chauds (17) sont prévus entre deux rangs, selon la direction Y, de paires froides (19) et/ou les tubes froids (18) sont prévus entre deux rangs, selon la direction Y, de paires chaudes (20).

22. Dispositif selon l'une des revendications 20 ou 21 comprenant des boîtes collectrices (23) pour le fluide chaud dans lequel les tubes chauds (17) débouchent par leurs extrémités.

23. Dispositif selon l'une des revendications 20 ou 21 dans lequel les tubes froids (18) sont également répartis en rangs s'étendant dans des plans orthogonaux à la direction Z et les tubes froids (18) d'un même rang orthogonal à Z sont reliés deux à deux par des conduits coudés (27) de façon à définir une circulation du fluide froid en serpentin dans ledit rang orthogonal à Z.

24. Dispositif selon la revendication 23 dans lequel les extrémités des serpentins sont reliées de part et d'autres à une boîte collectrice (28) dans laquelle ils débouchent.

25. Dispositif selon l'une des revendications 19 à 24 dans lequel :
- l'ailette froide (6f-u2) de la seconde paire froide amont et l'ailette froide (6f-d2) de la seconde paire froide aval sont mises au même potentiel, pour les ailettes des paires froides se trouvant à une première extrémité des séries de paires froides,
- l'ailette froide (6f-d1) de la première paire froide aval de l'une des paires chaudes est mise au même potentiel que l'ailette froide (6f-u1) de ladite première paire froide amont de la paire chaude suivante dans la direction Y, lesdites ailettes froides (6f-d1, 6f-u1) faisant partie de la même paire d'ailettes froides, pour les ailettes des paires froides se trouvant à l'autre extrémité des séries de paires froides.

26. Dispositif selon l'une quelconque des revendications 20 à 25 dans lesquels les ailettes des paires froides présentent le long de l'un et/ou l'autre de leurs côtés longitudinaux un bord plié (29) permettant d'isoler thermiquement le reste d'ailette d'une radiation de chaleur depuis les tubes chauds en vis-à-vis.

## Patentansprüche

1. Thermoelektrische Vorrichtung, umfassend eine erste Schaltung (1), heiße Schaltung genannt, die geeignet ist, die Zirkulation eines ersten Fluids zu ermöglichen, und eine zweite Schaltung (2), kalte Schaltung genannt, die geeignet ist, die Zirkulation eines zweiten Fluids mit geringerer Temperatur als jene des ersten Fluids zu ermöglichen, und so genannte thermoelektrische Elemente (3, 3p, 3n), die es ermöglichen, einen elektrischen Strom bei Vorhandensein eines Temperaturgradienten zu erzeugen, **dadurch gekennzeichnet, dass** sie Rippen (5f, 6f, 6c) in Wärmeaustauschverbindung mit der heißen Schaltung (1) und/oder der kalten Schaltung (2) umfasst, wobei die thermoelektrischen Elemente (3, 3p, 3n) zumindest mit den Rippen (5f, 6f, 6c) in Kontakt sind, wobei zumindest gewisse der Rippen (5f, 6f, 6c) paarweise zusammengefügt sind, wobei ein komprimierbares Material (11) zwischen den Rippen (5f, 6f, 6c) eines selben Paars vorgesehen ist.

2. Vorrichtung nach Anspruch 1, bei der das komprimierbare Material (11) elektrisch isolierend vorgesehen ist.

3. Vorrichtung nach Anspruch 1 oder 2, bei der die thermoelektrischen Elemente für einen ersten Teil (3p) von einem ersten Typ, P genannt, sind und es ermöglichen, einen elektrischen Potentialunterschied in eine so genannte positive Richtung zu erstellen, wenn sie einem gegebenen Temperaturgradienten unterzogen werden, und für den anderen Teil (3n) von einem zweiten Typ, N genannt, sind und die Erzeugung eines elektrischen Potentialunterschieds in eine entgegengesetzte so genannte negative Richtung ermöglichen, wenn sie demselben Temperaturgradienten unterzogen werden.

4. Vorrichtung nach Anspruch 3, bei der:
- die heiße Schaltung so genannte heiße Rohre (8) für die Zirkulation des heißen Fluids umfasst,
- die kalte Schaltung so genannte kalte Rohre (9) für die Zirkulation des kalten Fluids umfasst,
- die so genannten kalten Rippen (5f) mit den kalten Rohren (9) in Wärmeaustauschverbindung sind,
- die thermoelektrischen Elemente (3p, 3n) einerseits mit den heißen Rohren (8) und andererseits mit den kalten Rippen (5f) in Wärmeaustauschverbindung sind,
- die kalten Rippen (5f) paarweise gruppiert sind, wobei das komprimierbare Material (11) zwischen den Rippen eines selben Paars vorgesehen ist.

5. Vorrichtung nach Anspruch 3, bei der:
- die heiße Schaltung so genannte heiße Rohre (17) für die Zirkulation des heißen Fluids umfasst,
- die kalte Schaltung so genannte kalte Rohre (18) für die Zirkulation des kalten Fluids umfasst,
- für einen ersten Teil (6f) die so genannten kalten Rippen mit den kalten Rohren (18) in Wärmeaustauschverbindung sind,
- für den anderen Teil (6c) die so genannten heißen Rippen mit den heißen Rohren (17) in Wärmeaustauschverbindung sind,
- die thermoelektrischen Elemente (3p, 3n) einerseits mit den kalten Rippen (6f) und andererseits mit den heißen Rippen (6c) in Wärmeaustauschverbindung sind.

6. Vorrichtung nach Anspruch 5, bei der sich die kalten Rohre (17) und die heißen Rohre (18) in eine selbe so genannte Y-Richtung erstrecken, und die heißen Rippen (6c) und die kalten Rippen (6f) parallel zueinander in Ebenen orthogonal zur Y-Richtung angeordnet sind, wobei sich die Rippen (6f, 6c) in eine erste so genannte Z-Richtung und in eine zweite so genannte X-Richtung erstrecken.

7. Vorrichtung nach Anspruch 6, bei der nur die kalten Rippen (6f) paarweise (30) gruppiert sind, kaltes Paar genannt, und das komprimierbare Material (11) zwischen den Rippen (6f) eines selben Paars für die kalten Paare (30) vorgesehen ist.

8. Vorrichtung nach Anspruch 7, bei der die kalten Paare (30) mit den heißen Rippen (6c) in Y-Richtung alternieren, so dass mindestens ein so genanntes kaltes Paar (30) beiderseits einer so genannten heißen Rippe (6c) angeordnet ist, wobei die heiße Rippe gegenüber einer kalten Rippe (6f) des oder der so genannten stromaufwärtigen kalten Paare (30) vorgesehen ist, die sich auf einer Seite der heißen Rippe (6c) befinden, wobei die heiße Rippe (6c) auch gegenüber einer kalten Rippe (6f) des oder der anderen so genannten stromabwärtigen kalten Paare (30) angeordnet ist, die sich auf der anderen Seite der heißen Rippe (6c) befinden.

9. Vorrichtung nach Anspruch 8, bei der mindestens zwei kalte Paare (30) in der Verlängerung zueinander entlang der X-Richtung vorgesehen sind, die elektrisch voneinander isoliert sind.

10. Vorrichtung nach Anspruch 9, bei der:
- ein oder mehrere Elemente (3p) des Typs P zwischen der heißen Rippe (6c) und der kalten Rippe (6f-u1), die sich gegenüber befindet, eines ersten der stromaufwärtigen kalten Paare (30), erstes stromaufwärtiges kaltes Paar genannt, vorgesehen sind,
- ein oder mehrere Elemente (3n) des Typs N zwischen der heißen Rippe und der kalten Rippe (6f-u2), die sich gegenüber befindet, eines weiteren, so genannten zweiten stromaufwärtigen kalten Paars der stromaufwärtigen kalten Paare (30), das sich in der Verlängerung des ersten stromaufwärtigen kalten Paars befindet, vorgesehen sind,
- ein oder mehrere Elemente (3p) des Typs P zwischen der heißen Rippe (6c) und der kalten Rippe (6f-d1), die sich gegenüber befindet, eines ersten der stromabwärtigen kalten Paare (30), erstes stromabwärtiges kaltes Paar genannt, vorgesehen sind,
- ein oder mehrere Elemente (3n) des Typs N zwischen der heißen Rippe (6c) und der kalten Rippe (6f-d2), die sich gegenüber befindet, eines weiteren, so genannten zweiten stromabwärtigen kalten Paars der stromabwärtigen kalten Paare (30), das sich in der Verlängerung des ersten stromabwärtigen kalten Paars befindet, vorgesehen sind,
- wobei die thermoelektrischen Elemente (3p) des Typs P bzw. (3n) des Typs N einander beiderseits der heißen Rippe (6c) gegenüberliegen.

11. Vorrichtung nach Anspruch 10, bei der:
- die kalte Rippe (6f-u2) des zweiten stromaufwärtigen kalten Paars und die kalte Rippe (6f-d2) des zweiten stromabwärtigen kalten Paars auf dasselbe Potential gebracht werden, und
- die kalte Rippe (6f-u1) des ersten stromaufwärtigen kalten Paars und die kalte Rippe (6f-d1) des ersten stromabwärtigen kalten Paars auf dasselbe Potential gebracht werden.

12. Vorrichtung nach Anspruch 11, bei der:
- die Rippen (6f-u1, 6f-d1) der ersten stromaufwärtigen und stromabwärtigen kalten Paare einer der heißen Rippen (6c) auf dasselbe Potential wie jene gebracht werden, die den folgenden heißen Rippen (6c) in Y-Richtung zugeordnet sind,
- die Rippen (6f-u2, 6f-d2) der zweiten stromaufwärtigen und stromabwärtigen kalten Paare einer der heißen Rippen (6c) auf dasselbe Potential wie jene gebracht werden, die den folgenden heißen Rippen (6c) in Y-Richtung zugeordnet sind.

13. Vorrichtung nach Anspruch 6, bei der die kalten Rippen (6f) und die heißten Rippen (6c) paarweise gruppiert sind, kaltes Paar (19) bzw. heißes Paar (20) genannt, wobei das komprimierbare Material (11) zwischen den Rippen (6f, 6c) eines selben Paars für die kalten Paare (19) und die heißen Paare (20) vorgesehen ist.

14. Vorrichtung nach Anspruch 13, bei der die heißen Paare (20) und die kalten Paare (19) in Y-Richtung alternierend sind, so dass mindestens ein kaltes Paar (19) beiderseits eines heißen Paars (20) angeordnet ist, wobei eine heiße Rippe (6c-u) des heißen Paars gegenüber einer kalten Rippe des oder der so genannten stromaufwärtigen kalten Paare (19) vorgesehen ist, die sich auf einer Seite des heißen Paars (20) befinden, wobei die andere Rippe (6c-d) desselben heißen Paars (20) einer kalten Rippe des oder der anderen so genannten stromabwärtigen Paare der kalten Paare (19) gegenüberliegt, die sich auf der anderen Seite des heißen Paars (20) befinden.

15. Vorrichtung nach Anspruch 14, bei der mindestens zwei kalte Paare (19) in der Verlängerung zueinander in X-Richtung vorgesehen und elektrisch voneinander isoliert sind, die eine Reihe von kalten Rippen in X-Richtung bilden.

16. Vorrichtung nach Anspruch 15, bei der:
- ein oder mehrere Elemente (3p) des Typs P zwischen einer ersten (6c-u) der heißen Rippen eines heißen Paars und der kalten Rippe (6f-u1), die sich gegenüber befindet, eines ersten der stromaufwärtigen kalten Paare, erstes stromaufwärtiges kaltes Paar genannt, vorgesehen sind,
- ein oder mehrere Elemente des Typs N zwischen der ersten der heißen Rippen (6c-u) und der kalten Rippe (6f-u2), die sich gegenüber befindet, eines weiteren, so genannten zweiten stromaufwärtigen kalten Paars der stromaufwärtigen kalten Paare, das sich in der Verlängerung des ersten stromaufwärtigen kalten Paars befindet, vorgesehen sind,
- ein Element (3n) des Typs N zwischen der anderen heißen Rippe (6c-d) des heißen Paars und der kalten Rippe (6f-u1), die sich gegenüber befindet, eines ersten der stromabwärtigen kalten Paare, erstes stromabwärtiges kaltes Paar genannt, vorgesehen ist,
- ein Element (3p) des Typs P zwischen der anderen heißen Rippe (6c-d) des heißen Paars und der kalten Rippe (6f-u2), die sich gegenüber befindet, eines weiteren, so genannten zweiten stromabwärtigen kalten Paars der stromabwärtigen kalten Paare, das sich in der Verlängerung des ersten stromabwärtigen kalten Paars befindet, vorgesehen ist,
- wobei die thermoelektrischen Elemente (3p) des Typs P thermoelektrischen Elementen (3n) des Typs N beiderseits des heißen Paars (20) gegenüberliegen.

17. Vorrichtung nach Anspruch 16, umfassend eine Vielzahl von heißen Paaren (20) in der Verlängerung zueinander in X-Richtung und elektrisch voneinander isoliert, die eine Reihe von heißen Paaren in X-Richtung bilden.

18. Vorrichtung nach Anspruch 17, bei der die heißen Paare (20) auch in Reihen verteilt sind, in denen sie in Y-Richtung aufeinanderfolgen.

19. Vorrichtung nach Anspruch 18, bei der die kalten Paare auch in Reihen verteilt sind, in denen sie in Y-Richtung aufeinanderfolgen, wobei die heißen Paare und die kalten Paare in Zickzack-Anordnung vorgesehen sind.

20. Vorrichtung nach Anspruch 19, bei der die heißen Rohre (17) bzw. die kalten Rohre (18) in Reihen gruppiert sind, die sich in Ebenen orthogonal zur X-Richtung erstrecken.

21. Vorrichtung nach Anspruch 20, bei der die heißen Rohre (17) zwischen zwei Reihen in Y-Richtung von kalten Paaren (19) und/oder die kalten Rohre (18) zwischen zwei Reihen in Y-Richtung von heißen Paaren (20) vorgesehen sind.

22. Vorrichtung nach einem der Ansprüche 20 oder 21, umfassend Sammelbehälter (23) für das heiße Fluid, in die die heißen Rohre (17) mit ihren Enden münden.

23. Vorrichtung nach einem der Ansprüche 20 oder 21, bei der die kalten Rohre (18) auch in Reihen verteilt sind, die sich in Ebenen orthogonal zur Z-Richtung erstrecken, und die kalten Rohre (18) einer selben Reihe orthogonal zu Z paarweise durch gebogene Leitungen (27) verbunden sind, um eine Zirkulation des kalten Fluids in Serpentinen in der Reihe orthogonal zu Z zu definieren.

24. Vorrichtung nach Anspruch 23, bei der die Enden der Serpentinen beiderseits eines Sammelbehälters (28), in den sie münden, angeschlossen sind.

25. Vorrichtung nach einem der Ansprüche 19 bis 24, bei der:
- die kalte Rippe (6f-u2) des zweiten stromaufwärtigen kalten Paars und die kalte Rippe (6f-d2) des zweiten stromabwärtigen kalten Paars auf dasselbe Potential gebracht werden, und zwar für die Rippen der kalten Paare, die sich an einem ersten Ende der Reihen von kalten Paaren befinden,
- die kalte Rippe (6f-d1) des ersten stromabwärtigen kalten Paars eines der heißen Paare auf dasselbe Potential wie die kalte Rippe (6f-u1) des ersten stromaufwärtigen kalten Paars des folgenden heißen Paars in Y-Richtung gebracht wird, wobei die kalten Rippen (6f-d1, 6f-u1) Teil desselben Paars von kalten Rippen sind, und zwar für die Rippen der kalten Paare, die sich am anderen Ende der Reihen von kalten Paaren befinden.

26. Vorrichtung nach einem der Ansprüche 20 bis 25, bei der die Rippen der kalten Paare entlang der einen und/oder der anderen ihrer Längsseiten einen umgelegten Rand (29) aufweisen, der es ermöglicht, die übrige Rippe gegen eine Wärmestrahlung von den gegenüberliegenden Rohren zu isolieren.

## Claims

1. Thermoelectric device comprising a first circuit (1), referred to as a hot circuit, capable of allowing the circulation of a first fluid, and a second circuit (2), referred to as a cold circuit, capable of allowing the circulation of a second fluid with a temperature lower than that of the first fluid, and elements (3, 3p, 3n), referred to as thermoelectric elements, making it possible to generate an electric current in the presence of a temperature gradient, **characterized in that** it comprises fins (5f, 6f, 6c) in heat exchange communication with the said hot circuit (1) and/or the said cold circuit (2), the thermoelectric elements (3, 3p, 3n) being in contact at least with the said fins (5f, 6f, 6c), at least some of the said fins (5f, 6f, 6c) being associated in pairs, a compressible material (11) being provided between the fins (5f, 6f, 6c) of a given pair.

2. Device according to Claim 1, wherein the said compressible material (11) is electrically insulating.

3. Device according to Claim 1 or 2, wherein a first group (3p) of the thermoelectric elements are of a first type, referred to as the P type, making it possible to establish an electrical potential difference in one direction, referred to as the positive direction, when they are subjected to a given temperature gradient, and the other group (3n) of the thermoelectric elements are of a second type, referred to as the N type, making it possible to create an electrical potential difference in an opposite direction, referred to as the negative direction, when they are subjected to the same temperature gradient.

4. Device according to Claim 3, wherein:
- the hot circuit comprises tubes (8), referred to as hot tubes, for circulation of the hot fluid,
- the cold circuit comprises tubes (9), referred to as cold tubes, for circulation of the cold fluid,
- the said fins (5f), referred to as cold fins, are in heat exchange communication with the cold tubes (9),
- the thermoelectric elements (3p, 3n) are in heat exchange communication on the one hand with the hot tubes (8) and on the other hand with the cold fins (5f),
- the said cold fins (5f) are grouped in pairs, the said compressible material (11) being provided between the fins of a given pair.

5. Device according to Claim 3, wherein:
- the said hot circuit comprises tubes (17), referred to as hot tubes, for circulation of the hot fluid,
- the said cold circuit comprises tubes (18), referred to as cold tubes, for circulation of the cold fluid,
- a first group (6f) of the said fins, referred to as cold fins, are in heat exchange communication with the said cold tubes (18),
- the other group (6c) of the said fins, referred to as hot fins, are in heat exchange communication with the said hot tubes (17),
- the said thermoelectric elements (3p, 3n) are provided in heat exchange communication on the one hand with the cold fins (6f) and on the other hand with the hot fins (6c).

6. Device according to Claim 5, wherein the said cold tubes (17) and the said hot tubes (18) extend along the same direction, referred to as the Y direction, and the hot fins (6c) and the cold fins (6f) are arranged parallel to one another in planes orthogonal to the Y direction, the fins (6f, 6c) extending along a first direction, referred to as the Z direction, and along a second direction, referred to as the X direction.

7. Device according to Claim 6, wherein only the cold fins (6f) are grouped in pairs (30), referred to as cold pairs, and the said compressible material (11) is provided between the fins (6f) of a given pair in the case of the cold pairs (30).

8. Device according to Claim 7, wherein the cold pairs (30) alternate with the hot fins (6c) along the Y direction so that at least one said cold pair (30) lies on either side of a said hot fin (6c), the said hot fin being provided facing a cold fin (6f) of the cold pair or pairs (30), referred to as upstream pairs, lying on one side of the said hot fin (6c), the said hot fin (6c) also facing a cold fin (6f) of the other cold pair or pairs (30), referred to as downstream pairs, lying on the other side of the said hot fin (6c).

9. Device according to Claim 8, wherein at least two cold pairs (30) in extension of one another along the X direction and electrically insulated from one another are provided.

10. Device according to Claim 9, wherein:
- one or more P-type elements (3p) are provided between the said hot fin (6c) and the cold fin (6f-u1), lying opposite, of a first of the upstream cold pairs (30), referred to as the first upstream cold pair,
- one or more N-type elements (3n) are provided between the said hot fin and the cold fin (6f-u2), lying opposite, of another of the upstream cold pairs (30), referred to as the second upstream cold pair, lying in extension of the said first upstream cold pair,
- one or more P-type elements (3p) are provided between the hot fin (6c) and the cold fin (6f-d1), lying opposite, of a first of the downstream cold pairs (30), referred to as the first downstream cold pair,
- one or more N-type elements (3n) are provided between the hot fin (6c) and the cold fin (6f-d2), lying opposite, of another of the downstream cold pairs (30), referred to as the second downstream cold pair, lying in extension of the said first downstream cold pair,
- the P-type thermoelectric elements (3p) and N-type thermoelectric elements (3n), respectively, face one another on either side of the hot fin (6c).

11. Device according to Claim 10, wherein:
- the cold fin (6f-u2) of the second upstream cold pair and the cold fin (6f-d2) of the second downstream cold pair are placed at the same potential, and
- the cold fin (6f-u1) of the first upstream cold pair and the cold fin (6f-d1) of the first downstream cold pair are placed at the same potential.

12. Device according to Claim 11, wherein:
- the fins (6f-u1, 6f-d1) of the first upstream and downstream cold pairs of one of the said hot fins (6c) are placed at the same potential as those associated with the subsequent hot fins (6c) along the Y direction,
- the fins (6f-u2, 6f-d2) of the second upstream and downstream cold pairs of one of the said hot fins (6c) are placed at the same potential as those associated with the subsequent hot fins (6c) along the Y direction.

13. Device according to Claim 6, wherein the cold fins (6f) and the hot fins (6c) are grouped in pairs, referred to respectively as a cold pair (19) and a hot pair (20), and the said compressible material (11) is provided between the fins (6f, 6c) of a given pair in the case of the cold pairs (19) and the hot pairs (20).

14. Device according to Claim 13, wherein the hot pairs (20) and the cold pairs (19) are alternated along the Y direction so that at least one said cold pair (19) lies on either side of a said hot pair (20), a hot fin (6c-u) of the said hot pair being provided facing a cold fin of the cold pair or pairs (19), referred to as an upstream pair, lying on one side of the said hot pair (20), the other fin (6c-d) of the same hot pair (20) facing a cold fin of the other pair or pairs, referred to as a downstream pair, of the said cold pairs (19) lying on the other side of the said hot pair (20).

15. Device according to Claim 14, wherein at least two cold pairs (19) in extension of one another along the X direction and electrically insulated from one another are provided, forming a row of cold fins along the X direction.

16. Device according to Claim 15, wherein:
- one or more P-type elements (3p) are provided between a first (6c-u) of the hot fins of one said hot pair and the cold fin (6f-u1), lying opposite, of a first of the upstream cold pairs, referred to as the first upstream cold pair,
- one or more N-type elements are provided between the said first of the hot fins (6c-u) and the cold fin (6f-u2), lying opposite, of another of the upstream cold pairs, referred to as the second upstream cold pair, lying in extension of the said first upstream cold pair,
- an N-type element (3n) is provided between the other hot fin (6c-d) of the said hot pair and the cold fin (6f-u1), lying opposite, of a first of the downstream cold pairs, referred to as the first downstream cold pair,
- a P-type element (3p) is provided between the said other hot fin (6c-d) of the said hot pair and the cold fin (6f-u2), lying opposite, of another of the downstream cold pairs, referred to as the second downstream cold pair, lying in extension of the said first downstream cold pair,
- the P-type thermoelectric elements (3p) face N-type thermoelectric elements (3n) on either side of the hot pair (20).

17. Device according to Claim 16, comprising a plurality of hot pairs (20) in extension of one another along the X direction and electrically insulated from one another, forming a series of hot pairs along the X direction.

18. Device according to Claim 17, wherein the said hot pairs (20) are also distributed in rows in which they follow one another along the Y direction.

19. Device according to Claim 18, wherein the cold pairs are also distributed in rows in which they follow one another along the Y direction, the hot pairs and the cold pairs being provided in staggered rows.

20. Device according to Claim 19, wherein the hot tubes (17) and the cold tubes (18), respectively, are grouped in rows extending in planes orthogonal to the X direction.

21. Device according to Claim 20, wherein the hot tubes (17) are provided between two rows, along the Y direction, of cold pairs (19) and/or the cold tubes (18) are provided between two rows, along the Y direction, of hot pairs (20).

22. Device according to one of Claims 20 and 21, comprising collector manifolds (23) for the hot fluid, into which the hot tubes (17) open at their ends.

23. Device according to one of Claims 20 and 21, wherein the cold tubes (18) are also distributed in rows extending in planes orthogonal to the Z direction, and the cold tubes (18) of the same row orthogonal to Z are connected two-by-two to curved conduits (27) so as to define circulation of the cold fluid in a serpentine in the said row orthogonal to Z.

24. Device according to Claim 23, wherein the ends of the serpentines are connected on either side to a collector manifold (28), into which they open.

25. Device according to one of Claims 19 to 24, wherein:
- the cold fin (6f-u2) of the second upstream cold pair and the cold fin (6f-d2) of the second downstream cold pair are placed at the same potential, in the case of the fins of the cold pairs lying at a first end of the multiple series of cold pairs,
- the cold fin (6f-d1) of the first downstream cold pair of one of the hot pairs is placed at the same potential as the cold fin (6f-u1) of the said first upstream cold pair of the subsequent hot pair in the Y direction, the said cold fins (6f-d1, 6f-u1) forming part of the same pair of cold fins, in the case of the fins of the cold pairs lying at the other end of the multiple series of cold pairs.

26. Device according to any one of Claims 20 to 25, wherein the fins of the cold pairs have a folded edge (29) along one and/or the other of their longitudinal sides, making it possible to thermally insulate the rest of the fin against heat radiation from the hot tubes facing it.
